# EUROPEAN PATENT APPLICATION

(11) **EP 4 693 414 A1**
(43) Date of publication of application: **11.02.2026**
(21) Application number: 24779317.7
(22) Date of filing: 08.03.2024
(51) Int. Cl.: H01L 31/048, E06B 5/00, E06B 9/13, E06B 9/264, H02S 20/26, H02S 30/20

(54) **SOLAR BATTERY MODULE, SOLAR BATTERY GLASS, GLASS WINDOW, ROLLING SCREEN DEVICE, AND BLIND DEVICE**

(30) Priority: 24.03.2023 JP 2023048862
(71) Applicant: LIXIL Corporation, Tokyo 141-0033 (JP)
(72) Inventor: ISHII, Hisashi, Tokyo 141-0033 (JP)
(74) Representative: karo IP
(86) International application number: PCT/JP2024/009150
(87) International publication number: WO 2024/203186

(57) **Abstract**

A solar cell module 10 includes a solar cell layer 12, an encapsulant 14 covering the solar cell layer 12, and a pair of protective films 16 and 18 that sandwich, from both sides, the solar cell layer 12 covered with the encapsulant 14.

## Description

### TECHNICAL FIELD

The present invention relates to a solar cell module, and solar cell glass, a glass window, a roll-up screen device, and a window shade device using the solar cell module.

### BACKGROUND ART

Conventionally, solar cell glass of laminated glass type is known in which a solar cell layer is provided between a pair of glass panels. Further, solar cell multi-glazed glass of laminated multi-glazed glass type is also known in which a hollow layer is provided between solar cell glass of laminated glass type and a glass panel (see Patent Literature 1, for example).

### RELATED-ART LITERATURE

### PATENT LITERATURE

Patent Literature 1: Japanese Patent Application Laid-Open Publication No. 2017-85750

### SUMMARY OF INVENTION

### TECHNICAL PROBLEM

However, the solar cell glass of laminated glass type as described above has the problem of increased estimated dimensions and weight because the number of glass panels increases by one. As the estimated dimensions and weight increase, the opening dimensions and cross-sectional shape of the frame also need to be significantly modified.

The present invention has been made in view of such a problem, and a purpose thereof is to provide a solar cell module of which an increase in estimated dimensions and weight of glass can be reduced.

### SOLUTION TO PROBLEM

To solve the problem above, a solar cell module according to one embodiment of the present invention includes a solar cell layer, an encapsulant covering the solar cell layer, and a pair of protective films that sandwich, from both sides, the solar cell layer covered with the encapsulant.

Another embodiment of the present invention is solar cell glass. The solar cell glass includes a glass panel, and the abovementioned solar cell module attached to at least one of main surfaces of the glass panel.

Yet another embodiment of the present invention is a glass window that includes the abovementioned solar cell glass, and a frame that supports an outer circumferential edge of the solar cell glass.

Still yet another embodiment of the present invention is a roll-up screen device that includes the abovementioned solar cell module, and a wind-up drum that winds the solar cell module.

A further embodiment of the present invention is a window shade device that includes a plurality of slats, and the abovementioned solar cell module disposed on a slat.

### BRIEF DESCRIPTION OF DRAWINGS

[Fig. 1] Fig. 1 is a schematic sectional view of a solar cell module according to an embodiment.
[Fig. 2] Fig. 2 is a schematic sectional view of multi-glazed glass using the solar cell module according to the embodiment.

### DESCRIPTION OF EMBODIMENTS

In the following, the present invention will be described based on a preferred embodiment with reference to the drawings. The configurations described below are intended for illustration for understanding of the present disclosure, and the scope of the present disclosure is defined only by the scope of the claims attached herein. Like reference characters denote like or corresponding constituting elements and members in each drawing, and repetitive description will be omitted as appropriate. Also, the dimensions of a member may be appropriately enlarged or reduced in each drawing in order to facilitate understanding. Further, in each drawing, part of a member less important in describing the embodiment may be omitted.

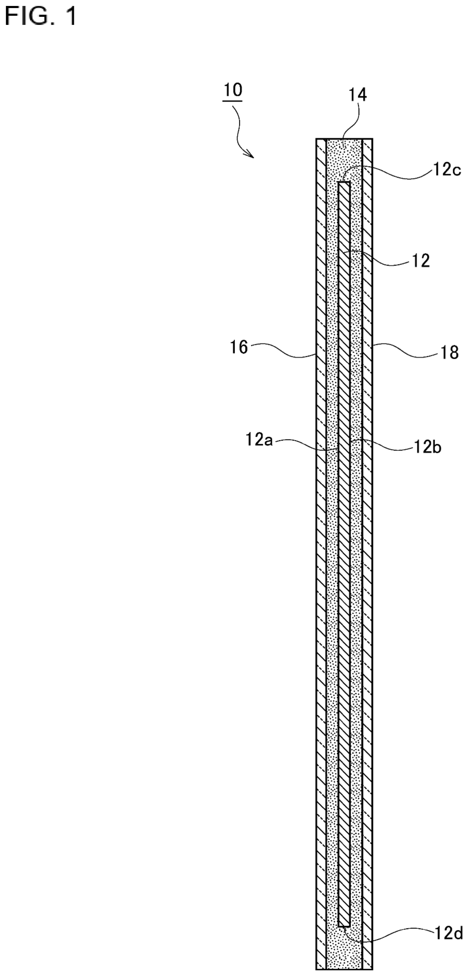

Fig. 1 is a schematic sectional view of a solar cell module 10 according to an embodiment. The solar cell module 10 is attached to glass and used.

As shown in Fig. 1, the solar cell module 10 includes a solar cell layer 12, an encapsulant 14 covering the solar cell layer 12, and a pair of protective films 16 and 18 that sandwich, from both sides, the solar cell layer 12 covered with the encapsulant 14.

The solar cell layer 12 is a layer in which multiple solar cells are arranged. The solar cells use photovoltaic effect and convert solar energy into electricity. In the solar cell layer 12, multiple solar cells are electrically connected in series to obtain a required predetermined voltage. The solar cell layer 12 may be made using thin-film silicon, an organic thin film, dye sensitization, perovskite, or the like. The solar cell layer 12 may be translucent or may be colored. The solar cells may be of monofacial type or may be of bifacial type.

The encapsulant 14 covers the entire solar cell layer 12. More specifically, the encapsulant 14 covers both surfaces (both main surfaces) 12a and 12b and side surfaces 12c and 12d of the solar cell layer 12. The encapsulant 14 may be made of a light transmitting material. For the encapsulant 14, ethylen-vinyl acetate (EVA), which is lightweight and durable, polyvinyl butyral (PVB), ionomers, silicone, and the like can be used, for example. The thickness of the encapsulant 14 may be 100 µm to 300 µm.

The pair of protective films 16 and 18 are provided to sandwich the both main surfaces 12a and 12b of the solar cell layer 12 covered with the encapsulant 14. The protective films 16 and 18 may be made of a light transmitting material. For the protective films 16 and 18, ETFE (Ethylene Tetra Fluoro Ethylene), polycarbonate (PC), polyethylene (PET), polystyrene (PS), polypropylene (PP), and the like may be used, for example. The thicknesses of the protective films 16 and 18 may be 25 µm to 250 µm.

The overall thickness of the solar cell module 10 may be 300 µm to 2000 µm. By applying glue to the surface of one of the protective films 16 and 18, the solar cell module 10 can be attached to glass and used. Since the solar cell module 10 is very thin, an increase in the estimated dimensions of the glass can be made smaller.

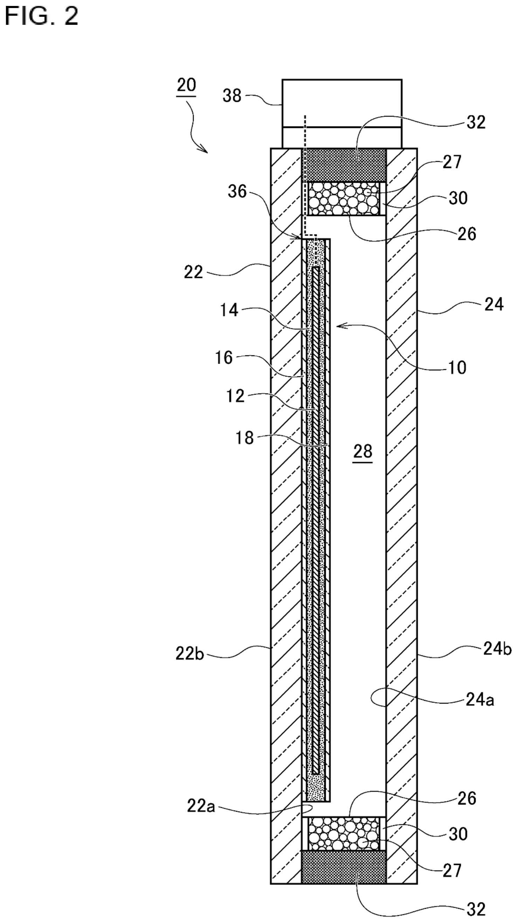

Fig. 2 is a schematic sectional view of multi-glazed glass using the solar cell module 10 according to the embodiment (hereinafter, referred to as "solar cell multi-glazed glass"). The outer circumferential edge of the solar cell multi-glazed glass shown in Fig. 2 is supported by a frame (sash). A glass window including the solar cell multi-glazed glass and the frame is placed in an opening or a spandrel part of a building.

As shown in Fig. 2, solar cell multi-glazed glass 20 includes a pair of glass panels 22 and 24 (hereinafter, referred to as the outdoor glass panel 22 and indoor glass panel 24, as appropriate) having translucency, and a spacer 26.

The solar cell multi-glazed glass 20 is configured as multi-glazed glass in which a hollow layer 28 is provided between the pair of glass panels 22 and 24 by means of the spacer 26, and dry air is sealed in the hollow layer 28. In the spacer 26, a hygroscopic agent 27 is provided to keep the air in the hollow layer 28 dry.

The circumferential edges of the pair of glass panels 22 and 24 are sealed by a sealing material, and the hollow layer 28 is sealed with no outside air flowing therein. The sealing material includes a primary sealing material 30 that seals between the spacer 26 and the pair of glass panels 22 and 24, and a secondary sealing material 32 that is disposed outside the spacer 26 and the primary sealing material 30 and that seals between the pair of glass panels 22 and 24. In the hollow layer 28, a noble gas such as Kr (krypton) and Ar (argon) may be sealed.

In the solar cell multi-glazed glass 20, an inner surface 22a of the outdoor glass panel 22 and an inner surface 24a of the indoor glass panel 24 face each other. Also, an outer surface 22b of the outdoor glass panel 22 faces the external space of the building, and an outer surface 24b of the indoor glass panel 24 faces the interior space.

The solar cell multi-glazed glass 20 includes the solar cell module 10 illustrated in Fig. 1 in the hollow layer 28. The solar cell module 10 is glued to the inner surface 22a of the outdoor glass panel 22.

At an end of the solar cell module 10, an extraction electrode 36 is provided to extract the current generated in the solar cell layer 12 to the outside. The extraction electrode 36 is extended out of the hollow layer 28 through the primary sealing material 30 and the secondary sealing material 32. The extraction electrode 36 thus extended is further extended into a terminal box 38 provided in an upper part of the solar cell multi-glazed glass 20 and is connected to a wiring cable (not illustrated) in the terminal box 38. The terminal box 38 is not limited to the upper part of the solar cell multi-glazed glass 20 and may be disposed in a side part or a lower part of the solar cell multi-glazed glass 20.

In the solar cell multi-glazed glass 20 configured as described above, since a thin solar cell module 10 is attached to the inner surface 22a of the outdoor glass panel 22, an increase in the estimated dimensions can be significantly reduced and the weight can also be significantly reduced, compared to conventional solar cell multi-glazed glass of laminated multi-glazed glass type. Although it depends on the thickness of the solar cell module 10, the estimated dimensions can be made almost the same as those of ordinary multi-glazed glass. Also, since the position of center of gravity does not change significantly compared to ordinary multi-glazed glass, there is no need to increase the cross-sectional performance, moment of inertia of area, and polar moment of inertia of area.

In the embodiment shown in Fig. 2, the solar cell module 10 is attached to the inner surface 22a of the outdoor glass panel 22. However, the surface to which the solar cell module 10 is attached is not limited thereto, and the solar cell module 10 may be provided on the outer surface 22b of the outdoor glass panel 22, the inner surface 24a of the indoor glass panel 24 (the surface on the hollow layer 28 side of the indoor glass panel 24), or the outer surface 24b of the indoor glass panel 24. Also, the solar cell module 10 may be provided on two or more surfaces.

Although the above describes an embodiment in which the solar cell module 10 is attached to a main surface of multi-glazed glass, the solar cell module 10 may be attached to at least one of the main surfaces of single-glazed glass. Also in this case, the increase in the estimated dimensions can be reduced compared to solar cell glass of laminated glass type.

The solar cell module 10 itself may be used as the screen of a roll-up screen device. Since the solar cell module 10 is very thin and flexible, it can be wound with a wind-up drum. Also, the solar cell module 10 can be made into a strip shape and attached or laminated to a slat of a window shade device that includes multiple slats arranged longitudinally.

The present invention has been described with reference to an embodiment. The embodiment is intended to be illustrative only, and it will be obvious to those skilled in the art that various modifications and changes could be developed within the scope of claims of the present invention and that such modifications and changes also fall within the scope of claims of the present invention. Therefore, the description in the present specification and the drawings should be regarded as illustrative rather than limitative.

### INDUSTRIAL APPLICABILITY

The present invention is applicable to solar cell modules attached to glass or the like.

### REFERENCE SIGNS LIST

10 solar cell module, 12 solar cell layer, 14 encapsulant, 16 protective film, 18 hollow layer, 20 solar cell multi-glazed glass, 22 outdoor glass panel, 24 indoor glass panel, 26 spacer, 28 hollow layer, 30 primary sealing material, 32 secondary sealing material, 36 extraction electrode, 38 terminal box

## Claims

1. A solar cell module, comprising:
a solar cell layer;
an encapsulant covering the solar cell layer; and
a pair of protective films that sandwich, from both sides, the solar cell layer covered with the encapsulant.

2. The solar cell module according to Claim 1, wherein the encapsulant is made of a light transmitting material.

3. The solar cell module according to Claim 1 or 2, wherein the pair of protective films are made of a light transmitting material.

4. Solar cell glass, comprising:
a glass panel; and
the solar cell module according to any one of Claims 1 through 3 attached to at least one of main surfaces of the glass panel.

5. A glass window, comprising:
the solar cell glass according to Claim 4; and
a frame that supports an outer circumferential edge of the solar cell glass.

6. A roll-up screen device, comprising:
the solar cell module according to any one of Claims 1 through 3; and
a wind-up drum that winds the solar cell module.

7. A window shade device, comprising:
a plurality of slats; and
the solar cell module according to any one of Claims 1 through 3 disposed on a slat.
